# EUROPÄISCHE PATENTSCHRIFT

(11) **EP 2 807 905 B1**
(45) Veröffentlichungstag und Bekanntmachung des Hinweises auf die Patenterteilung: **18.11.2015**
(21) Anmeldenummer: 14708789.4
(22) Anmeldetag: 07.02.2014
(51) Int. Cl.: H05K 3/30, H05K 1/02, H05K 13/04, H05K 13/08, H05K 3/32, H05K 3/34

(54) **BESTÜCKUNGSVERFAHREN FÜR SCHALTUNGSTRÄGER**
PLACEMENT METHOD FOR CIRCUIT CARRIER
PROCÉDÉ DE MONTAGE DE COMPOSANTS SUR UN SUPPORT DE CIRCUITS

(30) Priorität: 28.02.2013 AT 1552013
(43) Veröffentlichungstag der Anmeldung: 03.12.2014
(73) Patentinhaber: A.B. Mikroelektronik Gesellschaft mit beschränkter Haftung, 5020 Salzburg (AT)
(72) Erfinder: KARCH, Andreas, 83236 Übersee (DE)
(74) Vertreter: Gangl, Markus
(86) Internationale Anmeldenummer: PCT/AT2014/000027
(87) Internationale Veröffentlichungsnummer: WO 2014/153576

(56) Entgegenhaltungen:
- EP-A2- 1 003 212
- WO-A1-2009/031903
- US-A1- 2008 284 311
- US-A1- 2010 053 929
- US-A1- 2013 245 988

## Beschreibung

Die vorliegende Erfindung betrifft ein Verfahren zur Herstellung eines mit wenigstens einer oberflächenmontierten LED (SMD-LED) bestückten Schaltungsträgers mit den Merkmalen des Oberbegriffs des Anspruchs 1.

Zur Realisierung licht-optischer Anwendungen auf Basis von oberflächenmontierten LED Bauelementen (SMD-LED) ist eine hoch präzise Montage der SMD-LED Bauelemente auf einem Schaltungsträger erforderlich. Beispiele sind Frontscheinwerfer, Tagfahrlichter, Blinker, Kurvenlicht von Kraftfahrzeugen, deren Lichtquellen LED sind.

Hierbei sind die SMD-LED in Position zu einem oder mehreren definierten Referenzpunkten des Schaltungsträgers zu montieren, auf diese Referenzpunkte kann dann ein optisches System (z.B. Vorsatz-Linsen) ausgerichtet werden.

SMD-LED Bauelemente werden bisher im sogenannten "Pick & Place"-Verfahren auf den Schaltungsträgem platziert und anschließend im "Reflow"-Verfahren verlötet.
Hierbei wird die finale Position des lichtemittierenden Bereichs der LED von folgenden Faktoren bestimmt:
- die Toleranzen im LED-Bauelement (z.B. Position des lichtemittierenden Bereichs zur Außenkontur der LED bzw. zur Lage der Anschlusspads der LED),
- die Toleranzen im Schaltungsträger, welche die Position der Lötpads bestimmen (z.B. Leiterbahn-Lage zu Kontur des Schaltungsträgers und/oder eines Bohrlochs, Position der Lötstoppmaske zu einer Leiterbahnlage),
- die Bewegung der SMD-LED im Reflow-Löt-Prozess, verursacht durch das "Slumping" der Lötpaste in der Vorheizzone und die Benetzungskräfte des Lotes beim Aufschmelzen in der Peakzone (Aufschwimmen).

Die mit diesem Verfahren erreichbaren finalen Positioniergenauigkeiten des lichtemittierenden Bereichs von SMD-LED Bauelementen liegen allein bei Betrachtung der Toleranzen der SMD-LED und des Schaltungsträger (noch ohne Berücksichtigung der Einwirkung des Reflow-Löt-Prozesses) bereits bei mehr als +/- 110µm.

Die Einwirkungen des Reflow-Löt-Prozesses erzeugen zusätzliche Positionsungenauigkeiten, besonders im Bereich von Winkel- und Kipp-Positionstreue der SMD-LED Bauelemente.

Eine Aufbringung der SMD-LED mittels gängiger Silbersinterverfahren scheidet aus, da diese Verfahren mit inakzeptabel langen Prozesszeiten von mehr als
10 Sekunden verbunden sind.

Verfahren zur Bestückung eines Schaltungsträgers mit SMD-LED sind aus US 2010/0053929, US 2008/0284311, US 2013/245985 und WO 2009/031903 A1 bekannt.

Aus der EP 1 003 212 A2 geht ein Verfahren zur Herstellung eines mit einer SMD-LED bestückten Schaltungsträgers hervor, bei dem die Position eines lichtemittierenden Bereichs der SMD-LED optisch detektiert wird und die SMD-LED am Schaltungsträger in Abhängigkeit von der detektierten Position des lichtemittierenden Bereichs der SMD-LED montiert wird.

Aufgabe der Erfindung ist es ein gattungsgemäßes Verfahren bereitzustellen, mit welchem die zwangsläufig vorhandenen Toleranzen in den SMD-LED und den Schaltungsträgern kompensiert werden können, insbesondere eine höhere Genauigkeit bei Positionierung und Montage von SMD-LED auf Schaltungsträgern erzielt werden kann .

Diese Aufgabe wird durch ein Verfahren mit den Merkmalen des Anspruchs 1 gelöst.

Durch die Montage der wenigstens einen SMD-LED am Schaltungsträger in Abhängigkeit der Position des lichtemittierenden Bereichs in der SMD-LED ist es möglich jene Ungenauigkeiten auszuschalten, welche auf Toleranzen im LED-Bauelement und im Schaltungsträger zurückgehen. Hierdurch können Toleranzen bei der Positionierung der SMD-LED am Schaltungsträger von unter +/- 100 µm erreicht werden. Versuche der Anmelderin haben gezeigt, dass sogar Toleranzen von kleiner gleich +/- 50 µm erreichbar sind.

Mit anderen Worten ist es durch das erfindungsgemäße Verfahren möglich, die bauteil-immanenten Toleranzen von SMD-LED und Schaltungsträger weitgehend oder sogar vollständig auszuschalten. Das heißt, die erreichbaren Toleranzen sind beim erfindungsgemäßen Verfahren im Wesentlichen nur mehr durch die Präzision des verwendeten Detektionsverfahrens für den lichtemittierenden Bereich der SMD-LED begrenzt. Je nach Projektanforderungen kann demnach unabhängig vom Aufbau der SMD-LED und des Schaltungsträgers ein hinreichend präzises Detektionsverfahren ausgewählt werden und dadurch die Realisierung der im Projekt vorgeschriebenen Toleranzen erreicht werden. Mit anderen Worten können die größeren Toleranzen billigerer oder einfacherer Bauteile durch den Einsatz eines präziseren Detektionsverfahrens ausgeglichen werden. Ein präziseres Detektionsverfahren kann dadurch erreicht werden, dass eine genauere optische Kamera verwendet wird und/oder eine genauere "Pick & Place"-Vorrichtung verwendet wird.

Die Detektion des lichtemittierenden Bereichs der wenigstens einen SMD-LED kann beispielsweise durch die Verwendung einer optischen Kamera erfolgen, welche die charakteristische Kontur des lichtemittierenden Bereichs erkennt.

Vorteilhafte Ausführungsformen der Erfindung sind in den abhängigen Ansprüchen definiert.

Die Erfindung kann zum Beispiel bei Schaltungsträgern zum Einsatz kommen, welche für Frontscheinwerfer, Tagfahrlichter, Blinker, Kurvenlicht von Kraftfahrzeugen, deren Lichtquellen LED sind, verwendet werden.

Der Referenzpunkt bzw. die Referenzpunkte können zum Beispiel in Form von Löchern ausgebildet sein (Rund- oder Langlöcher). Zusätzlich oder alternativ können geätzte oder gedruckte Strukturen zum Einsatz kommen.

Zum Beispiel kann vorgesehen sein, dass die Montage der SMD-LED am Schaltungsträger in Abhängigkeit von der Position des Mittelpunkts des lichtemittierenden Bereichs der SMD-LED erfolgt. Dies ist deshalb besonders vorteilhaft, weil die Ausrichtung eines üblicherweise im Strahlengang der SMD-LED angeordneten optischen Systems im Hinblick auf den Mittelpunkt des lichtemittierenden Bereichs der SMD-LED erfolgt.

Besonders bevorzugt ist vorgesehen, dass zumindest einer der Referenzpunkte zur Positionierung und - vorzugsweise zur Befestigung - eines optischen Systems für die SMD-LED verwendet wird. Beim Stand der Technik muss der mit den SMD-LED bestückte Schaltungsträger relativ zum optischen System in einem eigenen Verfahrensschritt bei der Montage ausgerichtet werden. Dies kann bei der beschriebenen besonders bevorzugten Ausführungsform entfallen, da durch die Verwendung zumindest eines der Referenzpunkte zur Positionierung des optischen Systems dieses bereits korrekt ausgerichtet ist. Falls der zumindest eine Referenzpunkt nicht nur zur Positionierung des optischen Systems, sondern auch zur Befestigung des optischen Systems am Schaltungsträger verwendet wird (in diesem Fall ist der zumindest eine Referenzpunkt zum Beispiel als Montageloch für das optische System ausgebildet), ergibt sich die höchste Genauigkeit. Bei manchen Anwendungen kann es akzeptabel sein, gesonderte Befestigungsstellen für das optische System vorzusehen, welche in Bezug auf den zumindest einen Referenzpunkt ausgerichtet sind.

Um die wenigstens eine SMD-LED später an dem bzw. den Referenzpunkt(en) des Schaltungsträgers orientieren zu können, muss die Lage der Referenzpunkte des Schaltungsträgers erfasst werden. Dies kann beispielsweise so erfolgen, dass eine optische Kamera vorhandene Referenzpunkte abfährt und jeweils die Abweichung zur Sollposition, welche sich aus der Bauteil-immanenten Toleranz ergibt, ermittelt. Vorzugsweise wird die Lage jener Referenzpunkte verwendet, welche auch später zur Positionierung eines optischen Systems für die SMD-LED verwendet werden.

Üblicherweise werden SMD-LED in einem Zuführgurt bereitgestellt, aus welchem sie aus im Zuführgurt angeordneten Taschen mithilfe eines dem Stand der Technik entsprechenden "Pick & Place" Systems entnommen werden, zum Beispiel mithilfe eines Saugers (Vakuumpipette). Beim Stand der Technik werden die Konturen der SMD-LED oder die Lage der Anschlusspads nach Entnahme aus dem Zuführgurt von der Unterseite her detektiert. Dies ist bei der Erfindung nicht möglich, da hier die Lage des sich an der Oberseite des SMD-LED befindlichen lichtemittierenden Bereichs entscheidend ist. Beim Einsatz eines Vakuumpipettensystems muss daher die Detektion des lichtemittierenden Bereichs vor der Kontaktierung durch den Sauger erfolgen. Bei andersartig bereitgestellten SMD-LED muss dieses Erfordernis nicht unbedingt gegeben sein.

Beim Einsatz eines Vakuumpipettensystems kann die Erfindung wie folgt durchgeführt werden:

Mithilfe einer Kamera, welche so positioniert ist oder in eine solche Lage verfahrbar ist, dass sie in die einzelnen Taschen des Zuführgurtes hineinsehen kann, wird die Lage des lichtemittierenden Bereichs der zu entnehmenden SMD-LED detektiert. Vorzugsweise wird die detektierte Position verglichen mit einer Sollposition der SMD-LED in der Tasche, in welcher die SMD-LED mittig in der Tasche ausgerichtet an der Laufrichtung des Zuführgurtes (Y-Richtung, X-Richtung = Richtung rechtwinklig zur Y-Richtung in der Ebene des Zuführgurtes) angeordnet wäre. Es werden Abweichungen der detektierten Position des lichtemittierenden Bereichs zur Sollposition in Bezug auf die X- und Y-Richtung des Mittelpunkts des lichtemittierenden Bereichs sowie der Winkellage des lichtemittierenden Bereichs berechnet. Mit anderen Worten wird die zufällige Lage der SMD-LED in der Tasche des Zuführgurtes ermittelt und mit der Sollposition verglichen.

Die Detektion der Position des lichtemittierenden Bereichs wird dadurch robuster, dass die SMD-LED mit einer auf das LED-Spektrum angepassten Wellenlänge aufweisenden Lichtquelle beleuchtet wird. Dadurch kann der Kontrast zwischen dem lichtemittierenden Bereich und dem Restbereich der SMD-LED erhöht werden. Die angepasste Wellenlänge kann beispielsweise in einem Bereich von 400 bis 500 nm, vorzugsweise In einem Bereich von 420 bis 490 nm, liegen.

Diese zufällige Lage soll bei der Entnahme aus der Tasche durch die Vakuumpipette nicht mehr verändert werden. Um dies sicherzustellen, kann es vorteilhaft sein auch die Z-Position (Z-Richtung = rechtwinklig zur X- und Y-Richtung) des lichtemittierenden Bereichs oder der SMD-LED zu ermitteln, da dann die Kontaktierung durch die Vakuumpipette derart sanft erfolgen kann, dass es bei der Kontaktierung zu keiner Positionsveränderung der SMD-LED in der Tasche kommt.

Da durch Ermittlung der Lage der Referenzpunkte die Lage des Schaltungsträgers bekannt ist, kann mithilfe der ermittelten Abweichung des lichtemittierenden Bereichs der SMD-LED die Vakuumpipette so angesteuert werden, dass sie in X- und Y-Richtung sowie auch durch eine Drehung um eine Achse rechtwinklig zur SMD-LED die vorhandenen Abweichungen korrigieren und so die SMD-LED in Bezug auf den lichtemittierenden Bereich lagerichtig orientiert. Ein Verkippen der SMD-LED muss nicht berücksichtigt werden, da sie durch die Befestigung an der Vakuumpipette zur Achse der Vakuumpipette keinen Winkel aufweisen kann.

Im Folgenden werden zwei alternative Verfahren beschrieben, mit dem lagerichtig orientierte SMD-LED lagerichtig am Schaltungsträger montiert werden können:

Beim ersten Verfahren zur Montage der wenigstens einen SMD-LED am Schaltungsträger wird Silber-Sintermaterial an der wenigstens einer SMD-LED nach erfolgter Orientierung angeordnet und wenigstens eine SMD-LED silbergesintert.

Bevorzugt wird der zu bestückende Schaltungsträger und/oder die SMD-LED auf eine Temperatur gebracht, bei welcher beim und durch das Andrücken der mit Sintermaterial versehenen SMD-LED das Sintermaterial gesintert wird.

Um eine ausreichend kurze Prozesszeit zu ermöglichen, sollte die Partikelgröße des Silbersintermaterials kleiner als etwa 100 nm, bevorzugt kleiner als etwa 60 nm, sein. Dadurch wird ein Sintern innerhalb einer Kontaktzeit von weniger als 1 bis 5 Sekunden nach Beginn des Andrückens erreicht. Beispielsweise kann ein Sintermaterial mit einer Partikelgröße in einem Bereich von etwa 20 nm bis etwa 40 nm verwendet werden. Silbersintermaterial in der gewünschten Partikelgröße kann bei verschiedenen Anbietern erworben werden.

Das Anordnen des Silbersintermateriales auf der SMD-LED kann beispielsweise durch Auftragen einer Paste aus Silbersintermaterial und einem geeigneten organischen Trennmittel auf die SMD-LED erfolgen.

Die Paste kann beispielsweise ohne Veränderung der Lage der SMD-LED relativ zur Vakuumpipette durch Eintauchen der Anschlusspads in ein vorbereitetes Depot von Paste erfolgen.

Alternativ kann das Silbersintermaterial durch einen "Die Transfer Film" (DTF) auf die SMD-LED aufgebracht werden. In diesem Fall liegt das Silbersintermaterial in Filmform vor. Derartige Filme können kommerziell erworben werden.
Durch das Sintern kann es zu keiner nachträglichen Veränderung der lagerichtigen Orientierung der SMD-LED kommen, da die SMD-LED durch die Vakuumpipette solange festgehalten werden können, bis der Sintervorgang abgeschlossen ist. Ein Verkippen der SMD-LED kann nicht erfolgen, da sie durch die Vakuumpipette auf die Oberfläche des Schaltungsträgers angedrückt werden.

Das zweite Verfahren zur Montage der wenigstens einen SMD-LED am Schaltungsträger basiert auf einem Reflow-Lötverfahren,

Dabei wird Lötpaste auf den Schaltungsträger aufgebracht - vorzugsweise aufgedruckt. Anschließend wird ein Kleber - vorzugsweise in Abhängigkeit von der detektierten Position des lichtemittierenden Bereichs der wenigstens einen SMD-LED - auf den Schaltungsträger aufgebracht. Die SMD-LED wird am Schaltungsträger platziert. Anschließend wird der Kleber zumindest teilweise ausgehärtet. Dann kann ein Reflow-Löten der Lötpaste erfolgen.

Durch den Einsatz des Klebers kann ein Schwimmen der SMD-LED beim Reflow-Löten vermieden werden.

Besonders bevorzugt kommt als Kleber ein UV-härtbarer Kleber zum Einsatz. In diesem Fall kann das zumindest teilweise Aushärten des Klebers durch Belichtung mit UV-Licht erfolgen. Ganz besonders bevorzugt kommt ein Hybrid-Kleber zum Einsatz, welcher UV- und Temperatur-härtbar ist. Dieser kann beim Löten im Ofen nachhärten.

Es kann entweder ein individuelles Beleuchten jeder einzelnen SMD-LED erfolgen, bevorzugt erfolgt aber zur Verringerung der Taktzeit ein gleichzeitiges Beleuchten aller SMD-LED.

Weitere Vorteile und Einzelheiten der Erfindung ergeben sich anhand der Figuren sowie der dazugehörigen Figurenbeschreibung. In allen Figuren werden für gleiche Bestandteile gleiche Bezugszeichen verwendet.

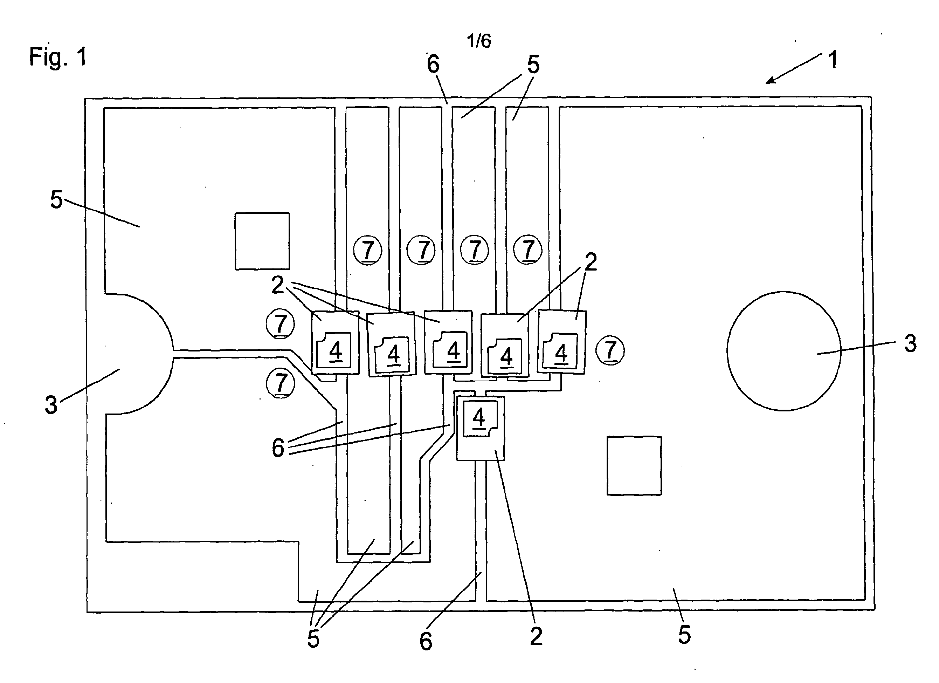

Die Figuren 1 bis 3 zeigen Test-Layouts, die dazu dienen die Positionsgenauigkeit jeder einzelnen SMD-LED 2 zu überprüfen. Der Schaltungsträger 1 weist elektrisch leitfähige Flächen 5 auf, die durch Isolationsbereiche 6 voneinander isoliert sind. Über Anschlüsse 7 können die leitfähigen Flächen 5 mit elektrischer Energie versorgt werden.

Figur 1 zeigt einen Schaltungsträger 1, der mit sechs SMD-LEO 2 bestückt ist. Zu erkennen sind zwei Referenzpunkte 3, welche einerseits zur Ermittlung der Abweichung der Sollpositionen für die SMD-LED 2 am Schaltungsträger 1 dienen und andererseits auch zur Befestigung eines nicht dargestellten optischen Systems für die SMD-LED 2 verwendet werden. Die Orientierung des optischen Systems erfolgt über gesonderte Referenzpunkte, die in dieser Figur nicht dargestellt sind.

Die Montage erfolgte bei Figur 1 mit einem "Pick & Place" und Reflow-Lötverfahren nach dem Stand der Technik. An sich sind die SMD-LED 2 anhand ihrer Außenkonturen relativ zu den Referenzpunkten 3 orientiert. Durch das Reflow-Lötverfahren ist es zu einem Verschwimmen der SMD-LED 2 gekommen, sodass keine geordnete Ausrichtung der Außenkonturen der SMD-LED 2 mehr gegeben ist. Eine Orientierung im Hinblick auf die lichtemittierenden Bereiche 4 der SMD-LED 2 ist überhaupt nicht erfolgt.

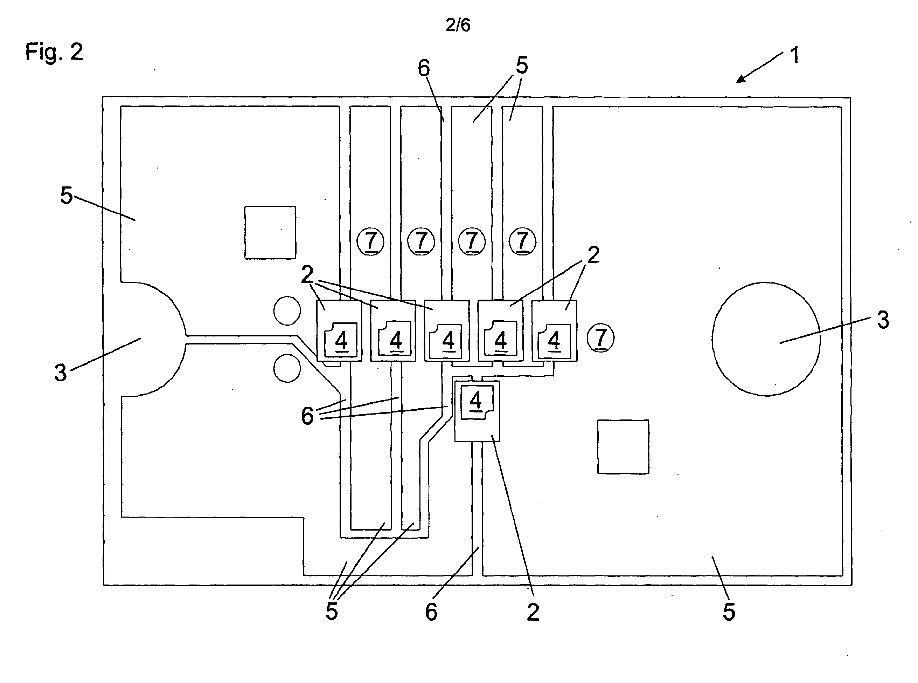

Figur 2 zeigt einen mit sechs SMD-LED 2 bestückten Schaltungsträger 1, wobei der Unterschied zur Figur 1 darin besteht, dass die SMD-LED 2 in Bezug auf die Außenkontur lagerichtig am Schaltungsträger 1 montiert sind, jedoch keine Montage in Abhängigkeit von den lichtemittierenden Bereichen 4 der SMD-LED 2 erfolgt ist. Auch dieser Schaltungsträger 1 erfüllt nicht die Anforderungen in Bezug auf die Positionsgenauigkeit der lichtemittierenden Bereiche 4.

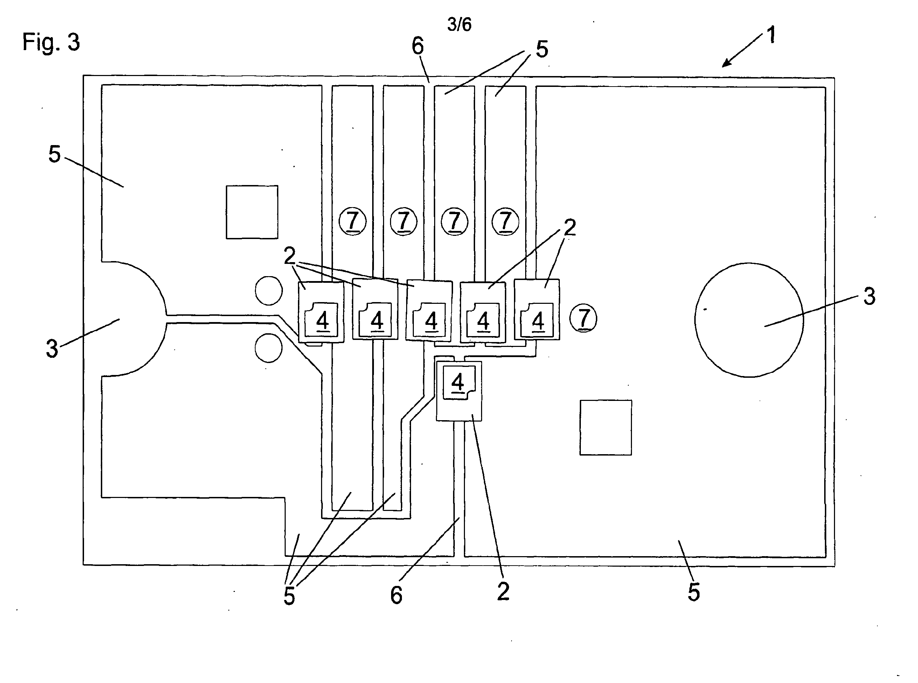

Figur 3 zeigt hingegen ein Ausführungsbeispiel der Erfindung, bei welchem die SMD-LED 2 im Hinblick auf Ihre lichtemittierenden Bereiche 4 lagerichtig relativ zu den Referenzpunkten 3 des Schaltungsträgers 1 am Schaltungsträger 1 montiert wurden. Dieser Schaltungsträger 1 erfüllt die Anforderungen in Bezug auf die Positionsgenauigkeit der lichtemittierenden Bereiche 4.

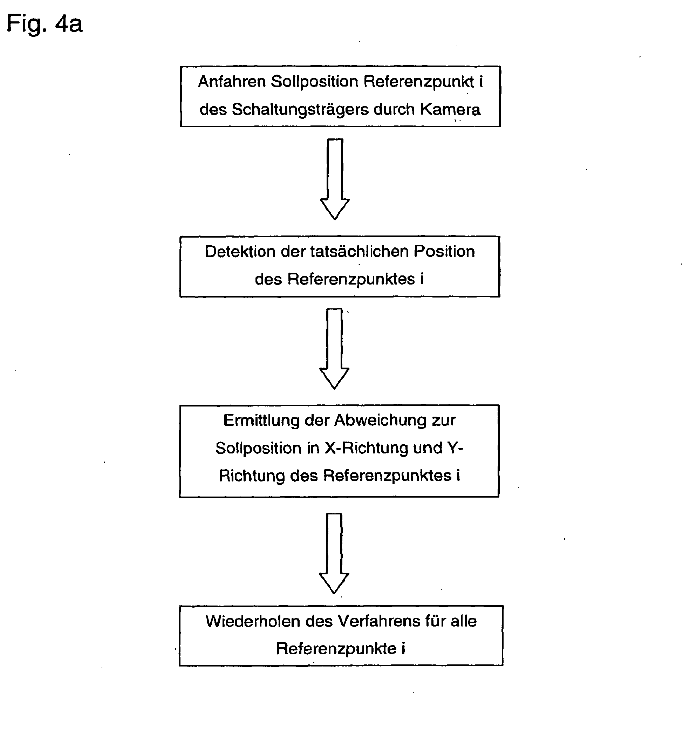

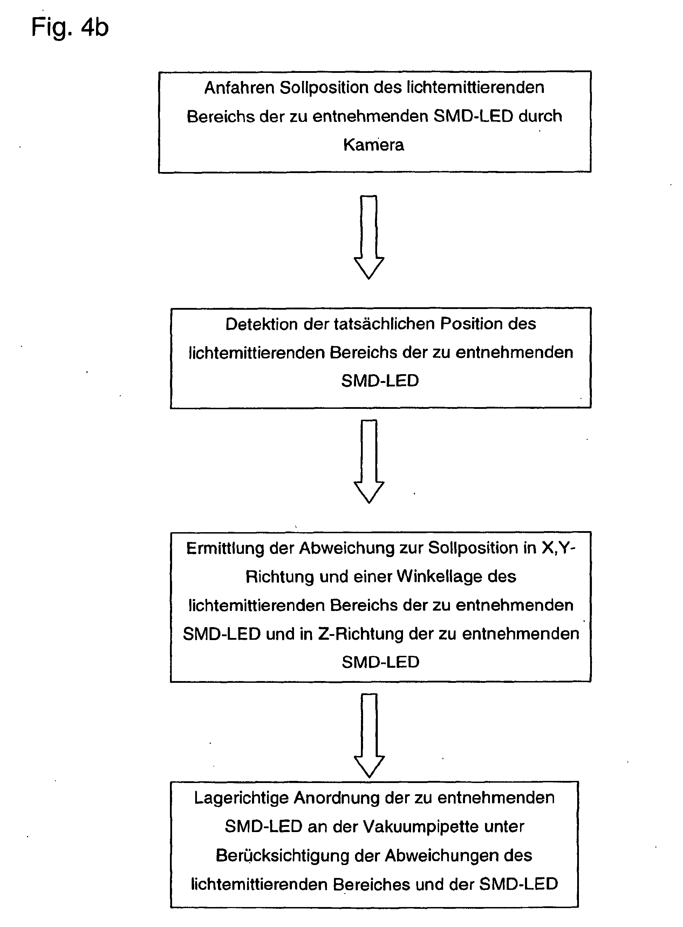

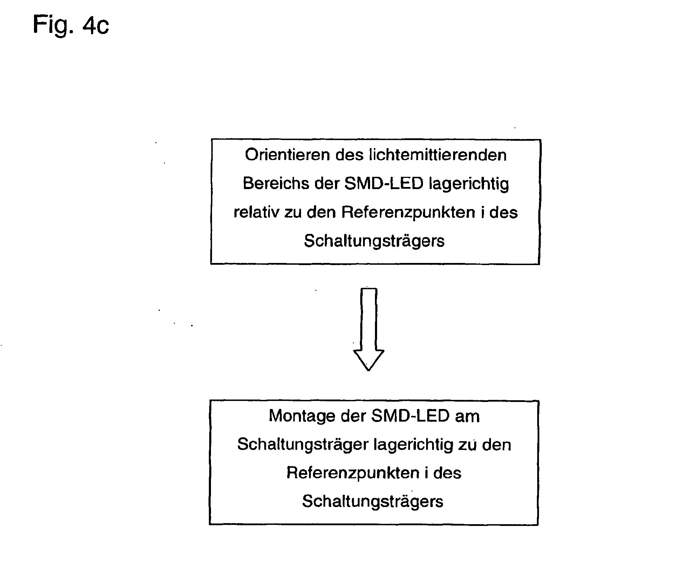

Die Figur 4 zeigt ein erfindungsgemäßes Verfahren umfassend die Schritte
- Ermittlung der Abweichung zur Sollposition in X-Richtung und Y-Richtung des Referenzpunktes 3 i für alle Referenzpunkte 3 i (Figur 4a)
- Ermittlung der Abweichung zur Sollposition in X,Y-Richtung und einer Winkellage des lichtemittierenden Bereichs 4 der zu entnehmenden SMD-LED 2 und in Z-Ricltung der zu entnehmenden SMD-LED 2 (Figur 4b)
- Montage der SMD-LED 2 am Schaltungsträger 1 lagerichtig zu den Referenzpunkten 3 i des Schaltungsträgers 1 (Figur 4c).

## Patentansprüche

1. Verfahren zur Herstellung eines mit wenigstens einer oberflächenmontierten LED (SMD-LED) bestückten Schaltungsträgers (1), wobei die wenigstens eine SMD-LED (2) orientiert an einem oder mehreren Referenzpunkten (3) des Schaltungsträgers (1) am Schaltungsträger (1) positioniert wird, wobei die Position eines lichtemittierenden Bereichs (4) der wenigstens einen SMD-LED (2) in der SMD-LED (2) optisch detektiert wird und die wenigstens eine SMD-LED (2) am Schaltungsträger (1) in Abhängigkeit von der detektierten Position des lichtemittierenden Bereichs (4) der wenigstens einen SMD-LED (2) montiert wird, **dadurch gekennzeichnet, dass** zur Detektion der Position des lichtemittierenden Bereichs (4) die SMD-LED (2) mit einer eine auf das LED-Spektrum angepasste Wellenlänge aufweisenden Lichtquelle beleuchtet wird.

2. Verfahren nach Anspruch 1, **dadurch gekennzeichnet, dass** die Position des lichtemittierenden Bereichs (4) in allen drei Dimensionen (X, Y, Z) und die Winkellage relativ zu einer Drehachse rechtwinklig zur Ebene der SMD-LED (2) bestimmt wird.

3. Verfahren nach Anspruch 1 oder 2, **dadurch gekennzeichnet, dass** die Montage der wenigstens einen SMD-LED (2) am Schaltungsträger (1) in Abhängigkeit von der Position des Mittelpunkts des lichtemittierenden Bereichs (4) der wenigstens einen SMD-LED (2) erfolgt.

4. Verfahren nach wenigstens einem der Ansprüche 1 bis 3, **dadurch gekennzeichnet, dass** zumindest einer der Referenzpunkte (3) zur Positionierung und - vorzugsweise zur Befestigung - eines optischen Systems für die wenigstens eine SMD-LED (2) verwendet wird.

5. Verfahren nach wenigstens einem der Ansprüche 1 bis 4, **dadurch gekennzeichnet, dass** zur Montage der wenigstens einen SMD-LED (2) am Schaltungsträger (1) Silber-Sintermaterial an der wenigstens einen SMD-LED (2) nach erfolgter Orientierung angeordnet und die wenigstens eine SMD-LED (2) - vorzugsweise bei und/oder durch Andrücken der wenigstens einen SMD-LED (2) auf den Schaltungsträger (1) - gesintert wird.

6. Verfahren nach Anspruch 5, **dadurch gekennzeichnet, dass** Silbersintermaterial mit einer Partikelgrößer von kleiner als etwa 100 nm, bevorzugt kleiner als etwa 60 nm, verwendet wird.

7. Verfahren nach Anspruch 6, **dadurch gekennzeichnet, dass** Silbersintermaterial mit einer Partikelgröße in einem Bereich von etwa 20 nm bis etwa 40 nm gewählt wird.

8. Verfahren nach wenigstens einem der Ansprüche 1 bis 4, **dadurch gekennzeichnet, dass** zur Montage der wenigstens einen SMD-LED (2) am Schaltungsträger (1)
- Lötpaste auf den Schaltungsträger (1) aufgebracht - vorzugsweise aufgedruckt - wird,
- ein Kleber - vorzugsweise in Abhängigkeit von der detektierten Position des lichtemittierenden Bereichs (4) der wenigstens einen SMD-LED (2) - auf den Schaltungsträger (1) aufgebracht wird,
- nach erfolgter Positionierung der wenigstens einen SMD-LED (2) am Schaltungsträger (1) der Kleber zumindest teilweise ausgehärtet wird,
- ein Reflow-Löten der Lötpaste erfolgt.

9. Verfahren nach einem der Ansprüche 1 bis 8, **dadurch gekennzeichnet, dass** die Detektion des lichtemittierenden Bereichs (4) der wenigstens einen SMD-LED (2) durch die Verwendung einer optischen Kamera erfolgt, welche die charakteristische Kontur des lichtemittierenden Bereichs (4) erkennt.

10. Verfahren nach einem der Ansprüche 1 bis 9, **dadurch gekennzeichnet, dass** sich der lichtemittierende Bereich (4) der wenigstens einen SMD-LED (2) an der Oberseite der SMD-LED (2) befindet.

## Claims

1. A process for the production of a circuit carrier (1) equipped with at least one surface-mount LED (SMD-LED), wherein the at least one SMD-LED (2) is positioned in oriented relationship to one or more reference points (3) of the circuit carrier (1) on the circuit carrier (1), wherein the position of a light-emitting region (4) of the at least one SMD-LED (2) is optically detected in the SMD-LED (2) and the at least one SMD-LED (2) is mounted to the circuit carrier (1) in dependence on the detected position of the light-emitting region (4) of the at least one SMD-LED (2), **characterised in that** for detecting the position of the light-emitting region the SMD-LED (2) is illuminated with a light source having a wavelength adapted to the LED spectrum.

2. A process according to claim 1 **characterised in that** the position of the light-emitting region (4) is determined in all three dimensions (X, Y, Z) and the angular position is determined relative to an axis of rotation at a right angle to the plane of the SMD-LED (2).

3. A process according to claim 1 or claim 2 **characterised in that** mounting of the at least one SMD-LED (2) to the circuit carrier (1) is effected in dependence on the position of the centre point of the light-emitting region (4) of the at least one SMD-LED (2).

4. A process according to at least one of claims 1 to 3 **characterised in that** at least one of the reference points (3) is used for positioning and - preferably for fixing - an optical system for the at least one SMD-LED (2).

5. A process according to at least one of claims 1 to 4 **characterised in that** for mounting the at least one SMD-LED (2) to the circuit carrier (1) silver sintering material is arranged at the at least one SMD-LED (2) after orientation has been effected and the at least one SMD-LED (2) is sintered - preferably upon and/or by pressing the at least one SMD-LED (2) on to the circuit carrier (1).

6. A process according to claim 5 **characterised in that** silver sintering material with a particle size of less than about 100 nm, preferably less than about 60 nm, is used.

7. A process according to claim 6 **characterised in that** silver sintering material is selected with a particle size in a range of about 20 nm to about 40 nm.

8. A process according to at least one of claims 1 to 4 **characterised in that** for mounting the at least one SMD-LED (2) to the circuit carrier (1)
- solder paste is applied to the circuit carrier (1) - preferably by printing thereon - ,
- an adhesive is applied to the circuit carrier (1) - preferably in dependence on the detected position of the light-emitting region (4) of the at least one SMD-LED (2) - ,
- the adhesive is at least partially hardened after positioning of the at least one SMD-LED (2) on the circuit carrier (1) has been effected, and
- Reflow soldering of the solder paste is effected.

9. A process according to at least one of claims 1 to 8 **characterised in that** the detection of the light-emitting region (4) of the at least one SMD-LED (2) is effected by the use of an optical camera which detects the characteristic contour of the light-emitting region (4).

10. A process according to at least one of claims 1 to 9 **characterised in that** the light-emitting region (4) of the at least one SMD-LED (2) is positioned at the top side of the SMD-LED (2).

## Revendications

1. Procédé de fabrication d'un support de circuit (1) équipé d'au moins une LED (SMD-LED) pour montage en surface, la au moins une SMD-LED (2) étant positionnée sur le support de circuit (1) de manière à être orientée vers un ou plusieurs points de référence (3) du support de circuit (1), où la position dans la SMD-LED (2) d'une zone d'émission lumineuse (4) de la au moins une SMD-LED (2) est optiquement détectée et où la au moins une SMD-LED (2) est montée sur le support de circuit (1) en fonction de la position détectée de la zone d'émission lumineuse (4) de la au moins une SMD-LED (2), **caractérisé en ce que**, pour la détection de position de la zone d'émission lumineuse (4), la SMD-LED (2) est éclairée par une source lumineuse présentant une longueur d'onde adaptée au spectre de la LED.

2. Procédé selon la revendication 1, **caractérisé en ce que** la position de la zone d'émission lumineuse (4) est déterminée dans les trois dimensions (X, Y, Z), et **en ce que** la position angulaire est déterminée par rapport à un axe de rotation perpendiculairement au plan de la SMD-LED (2).

3. Procédé selon la revendication 1 ou 2, **caractérisé en ce que** le montage de la au moins une SMD-LED (2) sur le support de circuit (1) est réalisé en fonction de la position du centre de la zone d'émission lumineuse (4) de la au moins une SMD-LED (2).

4. Procédé selon l'une des revendications 1 à 3, **caractérisé en ce qu'**au moins un des points de référence (3) est utilisé pour le positionnement et de préférence pour la fixation d'un système optique pour la au moins une SMD-LED (2).

5. Procédé selon l'une des revendications 1 à 4, **caractérisé en ce que**, pour le montage de la au moins une SMD-LED (2) sur le support de circuit (1), un matériau fritté d'argent est disposé après orientation sur la au moins une SMD-LED (2) et **en ce que** la au moins une SMD-LED (2) est frittée - préférentiellement lors, et/ou par pression de la ou des SMD-LED (2) sur le support de circuit (1).

6. Procédé selon la revendication 5, **caractérisé en ce que** le matériau fritté d'argent est utilisé avec une grandeur de particule inférieure à environ 100 nm, de préférence inférieure à environ 60 nm.

7. Procédé selon la revendication 6, **caractérisé en ce que** le matériau fritté d'argent est sélectionné avec une grandeur de particule comprise entre environ 20 nm et environ 40 nm.

8. Procédé selon l'une des revendications 1 à 4, **caractérisé en ce que** pour le montage de la au moins une SMD-LED (2) sur le support de circuit (1),
- une pâte à braser est appliquée - de préférence par impression - sur le support de circuit (1),
- une colle est appliquée sur le support de circuit (1) - de préférence en fonction de la position détectée de la zone d'émission lumineuse (4) de la au moins une SMD-LED (2),
- la colle est au moins partiellement durcie après positionnement de la au moins une SMD-LED (2) sur le support de circuit (1),
- un brasage par refusion de la pâte à braser est exécuté.

9. Procédé selon l'une des revendications 1 à 8, **caractérisé en ce que** la détection de la zone d'émission lumineuse (4) de la au moins une SMD-LED (2) est effectuée en recourant à une caméra optique qui reconnaît le contour caractéristique de la zone d'émission lumineuse (4).

10. Procédé selon l'une des revendications 1 à 9, **caractérisé en ce que** la zone d'émission lumineuse (4) de la au moins une SMD-LED (2) se trouve sur le dessus de la SMD-LED (2).
